(19) Europäisches Patentamt
European Patent Office
Office européen des brevets

(11) EP 2 282 335 A1

(12) EUROPÄISCHE PATENTANMELDUNG

(43) Veröffentlichungstag:
09.02.2011 Patentblatt 2011/06

(51) Int Cl.:
*H01L 23/473* (2006.01)

(21) Anmeldenummer: 09167251.9

(22) Anmeldetag: 05.08.2009

(84) Benannte Vertragsstaaten:
AT BE BG CH CY CZ DE DK EE ES FI FR GB GR
HR HU IE IS IT LI LT LU LV MC MK MT NL NO PL
PT RO SE SI SK SM TR
Benannte Erstreckungsstaaten:
AL BA RS

(71) Anmelder: SIEMENS AKTIENGESELLSCHAFT
80333 München (DE)

(72) Erfinder: Bleiweiss, Heinz
76437 Rastatt (DE)

(54) **Kühlvorrichtung und Verfahren**

(57) Kühlvorrichtung (1) zur Kühlung eines Bauteils (2), umfassend

- einen Kühlkörper (3),
- ein Gehäuse (4) mit einer inneren Kammer (5), wobei ein Volumen veränderndes Mittel (6) zum Zurückziehen eines Fluids in die Kammer (5) und zum Austreiben des Fluids aus der Kammer (5) ausgebildet ist, wobei das Zurückziehen einen ersten Strom (11) verursacht und das Austreiben Wirbel (7) verursacht, welche einen zweiten Strom (12) bilden, wobei ein Vorwärmmittel (8) dazu ausgestaltet ist den ersten Strom (11) und den zweiten Strom (12) zu führen und die Temperaturen,
- der von dem ersten Strom (11) mitgeführten ersten Fluidmenge (V1) beim Zurückziehen von einer Anfangstemperatur (T0) auf eine erste Temperatur (T1) zu erhöhen, und
- der von dem zweiten Strom (12) mitgeführten zweiten Fluidmenge (V2) von der ersten Temperatur (T1) auf eine zweite Temperatur (T2) zu erhöhen.

FIG 6

EP 2 282 335 A1

**Beschreibung**

Kühlvorrichtung und Verfahren

Die Erfindung betrifft eine Kühlvorrichtung zur Kühlung eines Bauteils, umfassend einen Kühlkörper, ein Gehäuse mit einer inneren Kammer, wobei ein volumenveränderndes Mittel zum Zurückziehen eines Fluids in die Kammer und zum Austreiben des Fluids aus der Kammer ausgebildet ist, wobei das Zurückziehen einen ersten Strom verursacht und das Austreiben Wirbel verursacht, welche einen zweiten Strom bilden.

Des Weiteren betrifft die Erfindung ein Verfahren zum Betrieb einer Kühlvorrichtung.

Die eingangs genannte Kühlvorrichtung ist beispielsweise aus folgenden Schriften bekannt US 6 588 497 B1, US 5 758 823 A1, US 5 988 522 A1 und US 7 252 140 B2 bekannt.

Es ist Aufgabe der vorliegenden Erfindung die nach dem Stand der Technik bekannten Vorrichtung und Verfahren hinsichtlich ihrer Kühlleistung zu optimieren.

Die Aufgabe wird für die gattungsgemäße Kühlvorrichtung dadurch gelöst, dass ein Vorwärmmittel dazu ausgestaltet ist den ersten Strom und den zweiten Strom zu führen und die Temperaturen, der von dem ersten Strom mitgeführten ersten Fluidmenge beim Zurückziehen von einer Anfangstemperatur auf eine erste Temperatur zu erhöhen, und der von dem zweiten Strom mitgeführten zweiten Fluidmenge von der ersten Temperatur auf eine zweite Temperatur zu erhöhen. Das Vorwärmmittel ist dabei vorteilhafter Weise mit dem Kühlkörper in thermischer Verbindung angeordnet und wird durch das am Kühlkörper angeordnete, beispielsweise elektrische, Bauteil erwärmt. Diese Erwärmung des Vorwärmmittels wird dazu benutzt bei einem Einsaugen des Stromes, das Fluid, beispielsweise Luft, von einer Anfangstemperatur auf eine erste Temperatur zu erwärmen. Mit dieser Erwärmung der Luft findet bereits eine Entwärmung des Vorwärmmittels statt und somit auch eine Entwärmung des Kühlkörpers, welches bereits zu einer Steigerung der Kühlleistung für das elektrische Bauteil führt.

In einer vorteilhaften Ausgestaltung weist die Kühlvorrichtung mit der Kammer, eine erste Kammer und eine zweite Kammer auf. Diese beiden, in einem Gehäuse angeordneten Kammern arbeiten mit dem volumenverändernden Mittel nach dem Prinzip eines bekannten synthetischen Jetantriebes.

In einer weiteren vorteilhaften Ausgestaltung weist das Vorwärmmittel einen ersten Kanal und einen zweiten Kanal auf. Der erste Kanal könnte somit an einen Auslass für eine erste Kammer und der zweite Kanal an einen Auslass für eine zweite Kammer angeschlossen werden. Die zweikanalige Ausprägung ist von Vorteil, da die beiden genannten Ströme getrennt voneinander geführt werden können.

In einer weiteren Optimierung der Kühlvorrichtung entspricht ein Volumen des ersten Kanals dem Volumen der ersten Fluidmenge. Auch ist es vorteilhaft, dass das Delta an Volumenänderungen, welches durch das volumenverändernde Mittel hervorgerufen wird, an das Volumen des ersten Kanals angepasst ist. Für eine Optimierung der Kühlleistung ist es also sinnvoll, den Rauminhalt des ersten Kanals an das Volumen, welches durch die Kammer angesaugt wird, anzupassen. Bei einer zweikanaligen Gestaltung der Erfindung, also einem ersten Kanal und einem zweiten Kanal ist eine symmetrische Auslegung im Hinblick auf die Volumina der Kanäle sinnvoll, dabei sollten die Volumina der Kanäle den Volumina der Kammern entsprechen bzw. das Volumen-Delta sollte dem Kanalvolumen entsprechen.

Zweckmäßig ist es, wenn der Kühlkörper das Vorwärmmittel als integrativen Bestandteil aufweist und ein Anteil der durch das Bauteil in den Kühlkörper fließenden Wärmestromes in das Vorwärmmittel fließt.

In einer weiteren Ausgestaltung weist der Kühlkörper eine Durchführung auf, welche derart angeordnet ist, dass der zweite Strom in die Durchführung strömt und sich die von dem zweiten Strom mitgeführte zweite Fluidmenge von der zweiten Temperatur auf eine dritte Temperatur erhöht. Der Kühlkörper mit seiner Durchführung sorgt für eine weitere Optimierung der gesteigerten Kühlleistung. Die durch den Kühlkörper geführte Luft kann bei dem Durchströmen durch die Durchführung auf eine weitere höhere Temperatur erwärmt werden und erreicht hierbei sogar, vorzugsweise eine thermische Sättigung. Das bedeutet, dass die durch das elektrische Bauteil in den Kühlkörper geführte Wärmemenge, mit dem Durchströmen des Stromes durch die Durchführung, dem Kühlkörper weiter entzogen werden kann.

Vorzugsweise ist das Vorwärmmittel mit einem ersten Ende und einem zweiten Ende zwischen einer Ansaugzone und dem Gehäuse angeordnet, dabei ist das erste Ende am Gehäuse angeordnet und das zweite Ende an der Ansaugzone zwischen dem Kühlkörper und dem zweiten Ende.

Die Kühlleistung kann noch weiter optimiert werden, wenn die Durchführung Leitmittel zum Erzwingen einer turbulenten Konvektion aufweist. Die turbulente Konvektion, wie sie aus der Physik nach der Rayleigh-Bénard Konvektion bekannt ist, ist ein fluidmechanischer Effekt. Bei diesem Vorgang wird ein Fluid zwischen zwei, vorzugsweise horizontalen, Platten von unten geheizt und von oben gekühlt. Bei einer Temperaturdifferenz, setzt ab einer gewissen Höhe die turbulente Konvektion ein, bei der sich großskalige thermische Strukturen aus den Grenzschichten lösen und warmes bzw. kaltes Fluid durch einen Kernbereich transportieren.

Eine Optimierung hinsichtlich einer Geräuschdämmung der Kühlvorrichtung wird dadurch erreicht, dass die Durchführung eine Austrittszone im Bereich einer Auslassöffnung aufweist, welche derart gestaltet ist, dass es zu einer Interferenz von Teilströmungen kommt und eine Schallkompensation erreichbar ist. Die Durchführung könnte somit im Bereich ihrer Austrittszone als ein Schalldämpfer ausgestaltet sein. In der Durchführung angeordnete Leitmittel für das Fluid wie z.B. Kaminlamellen an einer oberen und einer unteren Seite der Durchführung, sorgen neben einem phasenverschobenen Strom des ersten Stromes und des zweiten Stromes für eine entsprechende Interferenz der austretenden Luftverwirbelungen, so dass sich Schallwellen auslöschen. Insbesondere bei der Anwendung in Konsum-Elektronikgeräten, wie beispielsweise Laptops, ist eine geräuschgedämmte Kühlung des innerhalb des Laptops befindlichen Prozessors von Vorteil.

In einer weiteren Optimierung weist der Kühlkörper an einer Außenseite Kühllamellen auf.

Für besondere Umweltbedingungen ist es zweckmäßig, wenn die Kammer weiterhin eine dritte Kammer und eine vierte Kammer aufweist. Das Gehäuse mit den vier inneren Kammern ist somit als ein sogenannter gekapselter synthetischer Jetantrieb mit zwei Antriebssystemen ausgestaltet. Der besondere Vorteil bei dieser Ausgestaltung des synthetischen Jetantriebssystems ist, dass er Industrietauglich ist, da dieser staubdicht ausgestaltet ist.

Zur Funktion des synthetischen Jetantriebs mit vier Kammern und einer Ausgestaltung mit Staubdichtigkeit wird auf die Figurenbeschreibung verwiesen.

Verfahrensgemäß wird die eingangs genannte Aufgabe dadurch gelöst, dass für ein Verfahren nach dem Oberbegriff von Patentanspruch 12, der erste Strom durch ein Vorwärmmittel geführt wird, wobei eine Temperatur der von dem ersten Strom mitgeführten ersten Fluidmenge beim Zurückziehen von einer Anfangstemperatur auf eine erste Temperatur durch das Vorwärmmittel erhöht wird und die Temperatur von der durch den zweiten Strom mitgeführten zweiten Fluidmenge von der ersten Temperatur auf eine zweite Temperatur durch das Vorwärmmittel erhöht wird. Durch ein sozusagen oszillierendes Hin- und Herschaufeln von, beispielsweise Luftströmen, kann dem Vorwärmmittel in einer gezielten Steigerung Wärme entzogen werden. Eine Kühlleistung, beispielsweise eines elektrischen Bauteils wird somit optimiert. Es sei angemerkt, dass das Verfahren nicht nur zum Kühlen von elektrischen Bauteilen angewendet werden kann, sondern Anwendung in jeglicher technischer Anlage finden kann, bei der von einer Wärmequelle möglichst effizient die durch die Wärmequelle entstehende Wärme abtransportiert werden muss.

Für ein effektives Erzeugen des ersten und des zweiten Stromes wird das volumenverändernde Mittel derart angeregt, dass es ein oszillierendes Bewegungsmuster ausführt.

Zweckmäßig ist es dabei, dass die erste Bewegungsrichtung solange beibehalten wird, dass das Volumen der zurückgezogenen ersten Fluidmenge dem Volumen des ersten Kanals des Vorwärmmittels entspricht.

Weiterhin ist es zweckmäßig, dass die zweite Bewegungsrichtung solange beibehalten wird, dass das ausgetriebene Volumen der ersten Fluidmenge, dem Volumen des ersten Kanals des Vorwärmmittels entspricht und ein alternierender Austausch von Fluidmengen aus dem Vorwärmmittel durchgeführt wird.

Eine weitere Entwärmung des Vorwärmmittels und damit auch des Kühlkörpers und damit wiederum des elektrischen Bauteils wird dadurch erreicht, dass die Wirbel des zweiten Stromes in eine Durchführung des Kühlkörpers geleitet werden und die von dem zweiten Strom mitgeführte zweite Fluidmenge von der zweiten Temperatur auf eine dritte Temperatur erhöht wird. Es findet somit eine schrittweise Entwärmung statt. In einem ersten Schritt wird eine Anfangstemperatur, beispielsweise die Temperatur der Umgebungsluft, auf eine erste Temperatur angehoben. Diese angehobene Temperatur wird beim nochmaligen Durchführen durch das Vorwärmmittel wiederum von der ersten Temperatur auf eine zweite Temperatur angehoben und schließlich wird in einem dritten Schritt, die zweite Temperatur nochmals auf eine dritte Temperatur angehoben. Für das Beispiel mit der Umgebungsluft als Kühlfluid, würde dies bedeuten, dass nach dem Durchlaufen der genannten Schritte die als Umgebungsluft genutzt Kühlluft eine thermische Sättigung erreicht.

Eine Entwärmung kann weiter optimiert werden wenn die Wirbel von einem Leitmittel in der Durchführung abgelenkt werden und eine turbulente Konvektion erzeugt wird. Die turbulente Konvektion sorgt für eine schnellere Entwärmung der an den Grenzschichten der Durchführung auftretenden Wärmeströme.

Für den Betrieb der Kühlvorrichtung, insbesondere den Betrieb des volumenverändernden Mittels innerhalb des Gehäuses, innerhalb der Kammer, ist es zweckmäßig, die Bewegungsrichtungen abwechselnd hin und her auszuführen, so dass während einer ersten Zeitdauer für die erste Bewegungsrichtung, in welcher die erste Fluidmenge über eine Ansaugzone in den ersten Kanal gesogen wird, die zweite Fluidmenge aus einem zweiten Kanal ausgetrieben und in die Durchführung geleitet wird, wobei nach einem Umkehren der Bewegungsrichtung von der ersten Bewegungsrichtung in die zweite Bewegungsrichtung, die erste Fluidmenge in den zweiten Kanal gesogen und die zweite Fluidmenge aus dem ersten Kanal in die Durchführung geleitet wird.

In einer weiteren Ausgestaltung des Verfahrens wird eine bidirektionale Wärmeaufnahme durch die Ströme ausgeführt, die Ströme bis zu einer Austrittszone getrennt geführt und bei Austritt wird eine Schallemissionsreduktion ausgeführt.

Die Zeichnung zeigt drei Ausführungsbeispiele einer erfindungsgemäßen Kühlvorrichtung, dabei zeigt:

FIG 1 eine Kühlvorrichtung in einer ersten Ausgestaltungs- variante in einer Schnittdarstellung,

FIG 2 die Kühlvorrichtung in einer zweiten Ausgestaltungs- variante dargestellt,

FIG 3    die Ausgestaltungsvariante der Kühlvorrichtung nach FIG 2 in einer Draufsicht,

FIG 4    eine Prinzipskizze von Strömungskanälen mit einer Vorwärmzone,

FIG 5    eine prinzipielle Darstellung einer Vorrichtung zur Erzeugung eines ersten und eines zweiten Stromes,

FIG 6    die zweite Ausgestaltungsvariante der Kühlvorrichtung in einer perspektivischen Ansicht und

FIG 7    eine dritte Ausgestaltungsvariante der Kühlvorrich- tung ebenfalls in einer perspektivischen Ansicht.

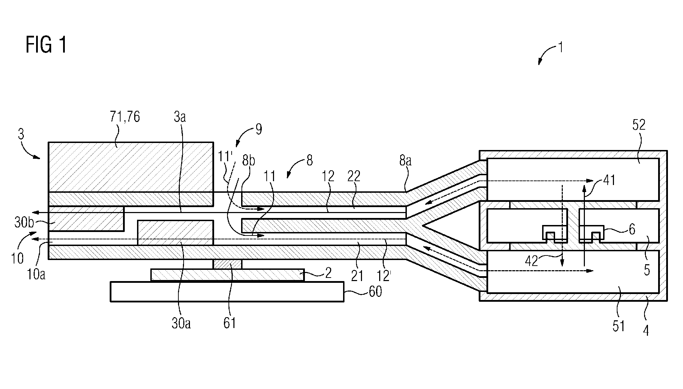

Gemäß FIG 1 ist in schematischer Darstellung eine Kühlvorrichtung 1 dargestellt. Von rechts nach links gesehen, zeigt die Kühlvorrichtung 1, als Hauptbestandteile ein Gehäuse 4, ein Vorwärmmittel 8 und einen Kühlkörper 3. Unterhalb des Kühlkörpers 3 ist ein Wärmeleitmittel 61 angeordnet, welches auf einem elektrischen Bauteil 2 platziert ist. Das elektrische Bauteil 2, beispielsweise ein Flip Chip BGA, ist auf einer Leiterplatte 60 angeordnet. Beim Betrieb des Flip Chip BGAs, insbesondere bei einer hohen Leistung, muss die durch den Flip Chip BGA erzeugte Wärme über das Wärmeleitmittel 61, über den Kühlkörper 3 abgeführt werden. Da eine effiziente Entwärmung heutzutage nur noch durch Hinzunehmen von aktiven Lüftern, wie beispielsweise nach dem Stand der Technik bekannten Radiallüftern zu erreichen ist, weist die Kühlvorrichtung 1 zur Optimierung der Kühlleistung des Kühlkörpers 3 ein Gehäuse 4 mit einer inneren Kammer 5 auf, welche wiederum eine erste Kammer 51 und eine zweite Kammer 52 aufweist.

Diese innerhalb des Gehäuses 4 angeordneten Kammern 51 und 52 sind durch ein volumenveränderndes Mittel 6 getrennt. Mit dieser Ausgestaltung innerhalb des Gehäuses 4 ist ein synthetischer Jetantrieb realisiert. Jede der beiden Kammern 51, 52 weist dabei eine Öffnung auf. Die Öffnung der ersten Kammer 51 ist mit einem ersten Kanal 21 des Vorwärmmittels 8 verbunden. Die Öffnung der zweiten Kammer 52 ist mit einem zweiten Kanal 22 des Vorwärmmittels 8 verbunden. Das volumenverändernde Mittel 6 ist als ein Piezoantrieb mit zwei beweglichen Membranen ausgestaltet. Der Piezoantrieb lässt eine erste Bewegungsrichtung 41 und eine zweite Bewegungsrichtung 42 der beweglichen Membranen zu.

Bei einem Betrieb des volumenverändernden Mittels 6 wird ein erster Strom 11 durch das Vorwärmmittel 8 geführt, wobei eine Temperatur der vom ersten Strom 11 mitgeführten ersten Fluidmenge V1 beim Zurückziehen der Membran von einer Anfangstemperatur auf eine erste Temperatur durch das Vorwärmmittel 8 erhöht wird und die Temperatur von der durch den zweiten Strom 12 mitgeführten zweiten Fluidmenge V2 von der ersten Temperatur T1 auf eine zweite Temperatur T2 durch das Vorwärmmittel 8 erhöht wird. Dabei werden der erste Strom 11 durch den ersten Kanal 21 und der zweite Strom 12 durch den zweiten Kanal 22 getrennt geführt.

Der erste Strom 11 und der zweite Strom 12 werden abwechselnd durch den ersten Kanal 21 und den zweiten Kanal 22 geführt, welches in FIG 1 als ein weiterer erster Strom 11' und ein weiterer zweiter Strom 12' dargestellt ist. Der erste Strom 11 und der dazu korrespondierende zweite Strom 12 sind als durchgezogene Linien dargestellt und der weitere erste Strom 11' und der dazu korrespondierende weitere zweite Strom 12' sind als gestrichelte Linien dargestellt.

Bei einem Ansaugvorgang mittels des volumenverändernden Mittels 6, wobei die Bewegungsrichtung 41 ausgeführt wird, entsteht in der ersten Kammer 51 ein Unterdruck und es kann dadurch über den ersten Kanal 21 der erste Strom 11 in den ersten Kanal 21 eingesaugt werden. Das volumenverändernde Mittel 6, die erste Kammer 51 und die Länge der Bewegungsrichtung 41 sind darauf abgestimmt, dass das durch die Bewegung entstehende Delta-Volumen dem Volumen des ersten Kanals 21 entspricht. Anstelle von allgemein gültigem Fluid wird jetzt von Luft gesprochen.

Die mit dem ersten Strom 11 eingesaugte Luftmenge befindet sich nun in dem ersten Kanal 21 und füllt dessen Volumen vollständig aus, während des Einsaugens und einer Verweildauer der Luftmenge in dem ersten Kanal 21 erwärmt sich die Luft von einer Anfangstemperatur T0 auf eine erste Temperatur T1. Die Luft fungiert also in einem ersten Schritt als eine Kühlluft.

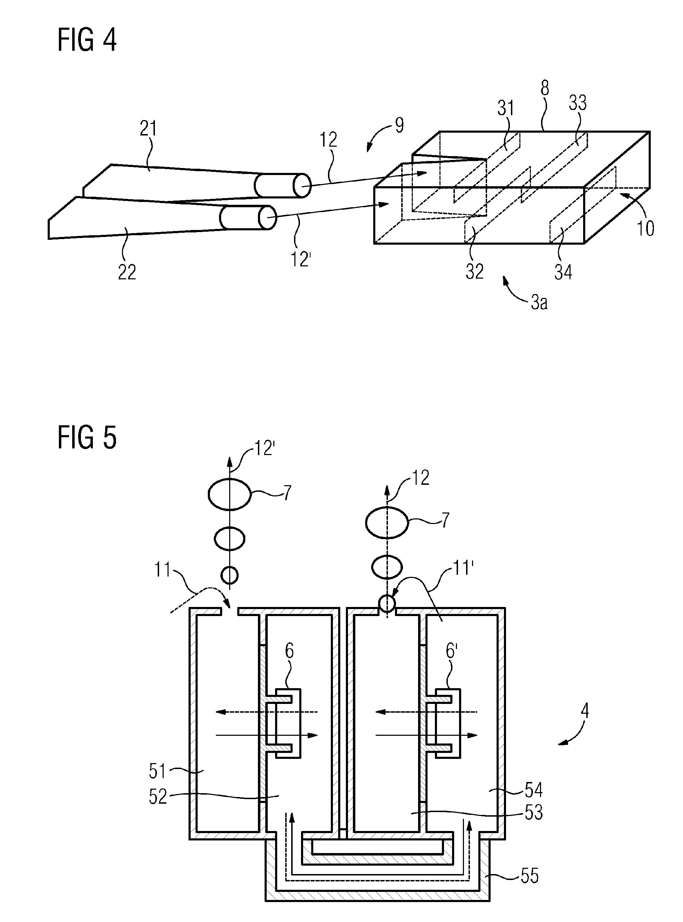

Zeitgleich zum Einsaugen der Kühlluft mittels des ersten Stromes 11 wird über das volumenverändernde Mittel 6 mit Hilfe der Kammer 52 und ihrer Öffnung, durch den zweiten Kanal 22, der zweite Strom 12 geführt. Beim Austritt des zweiten Stromes 12 aus der Öffnung der Kammer 52 entstehen durch das Austreiben Wirbel 7 (siehe FIG 5). Diese Wirbel 7 entsprechen einer zweiten Luftmenge V2, welche sich beim Durchströmen durch den zweiten Kanal 22 von der ersten Temperatur T1 auf eine zweite Temperatur T2 erwärmen können. Die Wirbel 7 in Form des zweiten Stromes 12 strömen aufgrund ihrer höheren Geschwindigkeit an einer Ansaugzone 9 vorbei und werden in den Kühlkörper 3 geleitet. Der Kühlkörper 3 weist dazu eine Durchführung 3a auf.

Innerhalb der Durchführung 3a sind Leitmittel zum Leiten der strömenden Luft angeordnet. Im oberen Teil der Durchführung 3a sind obere Kaminlamellen 30a und im unteren Teil der Durchführung 3a sind untere Kaminlamellen 30b angeordnet. Das Durchleiten des zweiten Stromes 12 durch die Durchführung 3a lässt die Kühlluft, welche sich bereits auf die zweite Temperatur T2 erwärmt hat noch einmal weiter ansteigen. Die Kühllufttemperatur erwärmt sich von der zweiten Temperatur T2 bei dem Durchströmen durch die Durchführung 3a auf die dritte Temperatur T3.

Diese Erwärmung bedeutet für die Kühlluft, dass thermische Sättigung erreicht ist. Die Leitmittel, obere Kaminlamellen 30a und untere Kaminlamellen 30b sorgen dafür, dass der erste Strom 12 in eine turbulente Konvektion 13 übergeht. Bei einer genügend großen Temperaturdifferenz setzt die turbulente Konvektion ein, welche durch die Leitmittel unterstützt wird, wobei sich thermische Strukturen aus den Grenzschichten der Durchführung 3a lösen und wärmeres Fluid bzw. die Luft in einen Kernbereich der Strömung transportiert wird und somit eine Kühlleistung des Kühlkörpers 3 optimiert wird.

Der Vorgang der Kühlung wurde zuvor am Beispiel des ersten Stromes 11 und des zweiten Stromes 12 erklärt. Da das volumenverändernde Mittel 6 ein oszillierendes Bewegungsmuster ausführt, sind die Strömungseigenschaften und die Temperaturerhöhung analog für den weiteren ersten Strom 11' und den weiteren zweiten Strom 12' zu erklären.

Bei der Ansauszone 9 kommt es über eine Sogwirkung zu einer gewünschten Beimischung nicht erwärmter Umgebungsluft. Der Kühlkörper 3 weist an seiner Außenseite Kühllamellen 71,...,76 auf. Diese zusätzlichen offenen Kühllamellen 71,...,76 an der Außenseite des Kühlkörpers 3 und damit an der Außenseite der Durchführung 3a unterstützen durch eine natürliche Konvektion der Umgebungsluft die Kühlleistung des Kühlkörpers 3. Unter anderem bestimmt das Wärmeabführvermögen der Kühllamellen 71,...,76 einen Arbeitspunkt (Umgebungstemperatur) des Einsatzes der Kühlvorrichtung 1. In Kombination mit der zuvor beschriebenen erzwungenen Konvektion.

An einer Austrittszone 10 kommt es zu einer gewünschten Interferenz der ausströmenden Luft und damit zu einer Reduktion einer Schallemission der austretenden Luft.

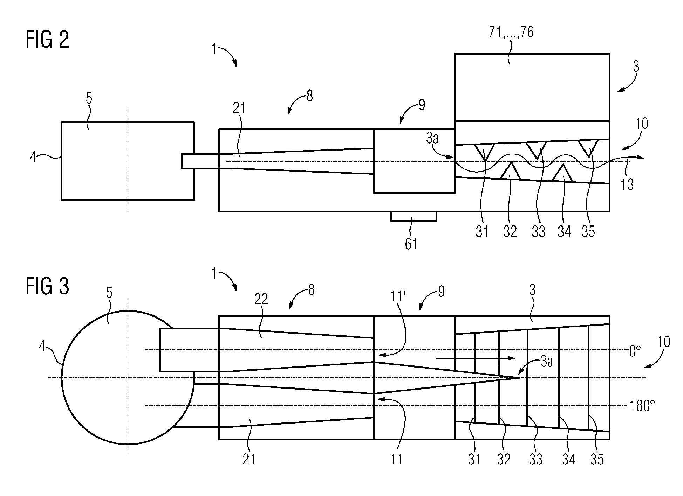

Mit FIG 2 ist eine zweite Ausführungsvariante der Kühlvorrichtung 1 schematisch in einer seitlichen Schnittdarstellung abgebildet. Im Gegensatz zu dem Ausführungsbeispiel nach FIG 1 sind der erste Kanal 21 und der zweite Kanal 22 nun nebeneinander angeordnet, so dass in FIG 2 nur der erste Kanal 21 ersichtlich ist. Diesmal von links nach rechts gesehen, ist die Kühlvorrichtung 1 aus dem Gehäuse 4 mit der inneren Kammer 5, dem Vorwärmmittel 8 mit einer Ansaugzone 9 und dem Kühlkörper 3 mit der Durchführung 3a aufgebaut. Durch den ersten Kanal 21 ist eine Symmetrieachse zeichnerisch angedeutet. Um diese Symmetrieachse werden sich jeweils der zweite Strom 12 und der weitere zweite Strom 12' bewegen. Zum Erreichen einer turbulenten Konvektion 13 innerhalb der Durchführung 3a sind von links nach rechts gesehen eine erste Kaminlamelle 31, eine zweite Kaminlamelle 32, eine dritte Kaminlamelle 33, eine vierte Kaminlamelle 34 und eine fünfte Kaminlamelle 35 angeordnet. Die Kaminlamellen 31, 33, 35 bilden dabei die oberen Kaminlamellen und die Kaminlamelle 32 und 34 bilden die unteren Kaminlamellen. Bei Auftreten der turbulenten Konvektion 13 wird eine Sogwirkung über die Ansaugzone 9 verstärkt und über die Ansaugzone 9 kann frische Umgebungsluft zum weiteren Kühlen zugeführt werden.

Mit FIG 3 ist die aus FIG 2 bekannte Kühlvorrichtung 1 schematisch in einer Draufsicht dargestellt. In dieser Ansicht wird der neben dem ersten Kanal 21 angeordnet Kanal 22 sichtbar. Die Kanäle 21, 22 sind jeweils in Strömungsrichtung verjüngend ausgeführt, so dass sich der Bernoullieffekt bemerkbar macht. Über die Ansaugzone 9 kann der erste Strom 11 in den ersten Kanal 21 und der weitere erste Strom 11' in den zweiten Kanal 22 eingesaugt werden. Durch die gegenläufige Bewegung des volumenverändernden Mittels 6 nach FIG 1 wird wie bei einem Zweitakt-Motor über den ersten Kanal 21 angesaugt während über den zweiten Kanal 22 ausgestoßen wird und umgekehrt.

In der Durchführung 3a sind Kanten der ersten Kaminlamelle 31 bis zur fünften Kaminlamelle 35 sichtbar. Mit FIG 2 wird deutlich, dass die Durchführung 3a eine erste Eintrittsöffnung und eine zweite Eintrittsöffnung aufweist, wobei in Strömungsrichtung gesehen die Eintrittsöffnungen in ihrem Querschnitt zunehmen. Diese Zunahme ist ungefähr bis zur Hälfte der Durchführung 3a ausgestaltet, und ab dieser Hälfte vereinigen sich die zuvor zwangsgeführten Ströme zu einem gemeinsamen Strom. Bei der Vereinigung entstehen Interferenzen, welche durch die Anordnung der dritten, vierten und fünften Kaminlamelle 31, 34, 35 derart begünstigt werden, dass bei Austritt aus der Austrittszone 10 für die strömende Luft eine Schallemission erreicht wird.

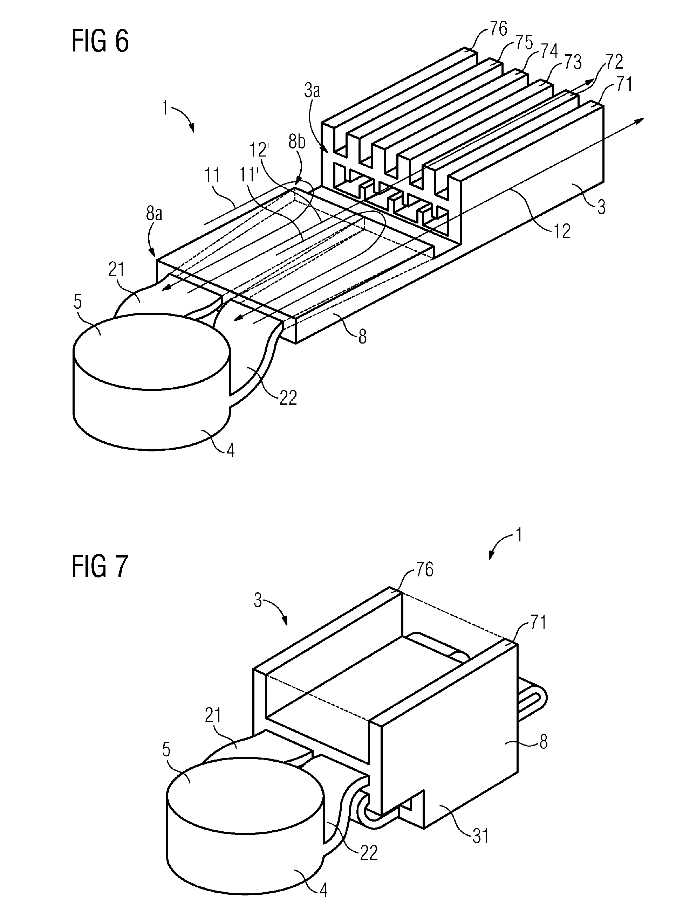

Das mit FIG 6 dargestellte zweite Ausführungsbeispiel einer Kühlvorrichtung 1 zeigt in dieser Darstellung als Unterschied Kanalbögen für den ersten Kanal 21 und den zweiten Kanal 22. Die innerhalb des Gehäuses 4 angeordneten bekannten Mittel zur Erzeugung der Ströme stehen mit ihren bereits beschriebenen Öffnungen jeweils mit dem ersten Kanal 21 und dem zweiten Kanal 22 in Verbindung. Das Gehäuse 4 ist somit über die Kanäle 21, 22 mit einem ersten Ende 8a des Vorwärmmittels 8 verbunden. Innerhalb des Vorwärmmittels 8 werden die Kanäle 21 und 22 getrennt voneinander, bis zu einem zweiten Ende 8b des Vorwärmmittels 8 geführt. Zwischen dem zweiten Ende 8b und dem Kühlkörper 3 befindet sich eine Aussparung, welche als die Ansaugzone 9 ausgestaltet ist.

Das Vorwärmmittel 8 ist als integrativer Bestandteil des Kühlkörpers 3 ausgestaltet. Der in dem Kühlkörper 3 aufgrund einer Wärmequelle (elektrisches Bauteil 2) fließende Wärmestrom kann somit auch in das Vorwärmmittel 8 strömen, dieses Erwärmen und mittels der Kanäle die durch die Kanäle 21, 22 strömende Umgebungsluft erwärmen. Wie bereits mit FIG 1 erläutert, wird der erste Strom 11 über die Ansaugzone 9 in den ersten Kanal 21 eingesaugt. Zeitgleich während des Einsaugvorganges wird über den zweiten Kanal 22 der zweite Strom 12 als ein Wirbelstrom durch den zweiten Kanal 22 ausgetrieben und in die Durchführung 3a geleitet. Die Durchführung 3a weist in diesem Beispiel längs angeordnetem Leitmittel, wie Leitlamellen, auf. Der Kühlkörper 3 weist an seiner Außenseite Kühllamellen 71,...,76 auf.

Ein drittes Ausführungsbeispiel der Kühlvorrichtung 1 zeigt die FIG 7 perspektivischer Darstellung, wobei sich die Kanäle 21 und 22 meanderartig durch den Kühlkörper 3 und das Vorwärmmittel 8 schlängeln. Bei dieser Ausgestaltungsvariante gilt als Besonderheit, dass der Kühlkörper 3 zur seitlichen Begrenzung eine erste Kühllamelle 71 und eine zweite Kühllamelle 76 aufweist. Es ergibt sich somit ein breiter Kanal für eine natürliche Konvektion der Umgebungsluft an den beiden Lamellen 71, 76. Das Vorwärmmittel 8 als Vorwärmzone ist nun nicht in Reihe mit dem Kühlkörper angeordnet sondern befindet sich unterhalb des eigentlichen Kühlkörpers 3 ist aber dennoch thermisch mit dem Kühlkörper 3 und seinen Kühllamellen 71, 76 verbunden.

Gemäß FIG 4 wird schematisch gezeigt, wie die Durchführung 3a aufgebaut sein kann. Aus dem ersten Kanal 21 strömt der zweite Strom 12 und aus dem zweiten Kanal 22 strömt der weitere zweite Strom 12' in Richtung der Durchführung 3a. Die Durchführung 3a weist dabei im Anschluss an eine Ansaugzone 9 eine erste Öffnung und eine zweite Öffnung auf. Diese beiden Öffnungen führen den zweiten Strom 12 und den weiteren zweiten Strom 12' bis zu einer ersten Kaminlamelle 31 getrennt. Ab der ersten Kaminlamelle 31 wird der zweite Strom 12 und der zweite Strom 12' vereinigt und diese beiden vereinigten Ströme können auf eine, in Strömungsrichtung gesehen, weiter hinten angeordnete zweite Kaminlamelle 32 auftreffen und für eine vorzugsweise turbulente Konvektion 13 vorbereitet oder bereits verwirbelt worden sein. Weiter in Strömungsrichtung angeordnet befindet sich eine dritte Kaminlamelle 33 und weiter hinten in Strömungsrichtung befindet sich im Bereich einer Austrittszone 10 eine vierte Kaminlamelle 34.

Mit FIG 5 ist ein Gehäuse 4 dargestellt, welches im Inneren dazu ausgestaltet ist, die Funktion eines synthetischen Jetantriebes auszuführen. Dieser synthetische Jetantrieb weist eine erste Kammer 51, eine zweite Kammer 52, eine dritte Kammer 53 und eine vierte Kammer 54 auf. Die erste Kammer 51 und die dritte Kammer 53 weisen jeweils eine Öffnung zum Einsaugen bzw. Ausblasen eines Fluids auf. Über die Öffnungen wird ein erster Strom 11 sowie ein weiterer erster Strom 11' eingesaugt. Die beiden Kammern 51 und 53 arbeiten im Wechseltakt, d.h. wird über die Öffnung der Kammer 51 ein erster Strom 11 eingesaugt, so wird über die Öffnung der Kammer 53 der zweite Strom 12 ausgetrieben. Dabei gestaltet sich der zweite Strom 12 aus einer Reihe von Wirbeln 7, diese Wirbel 7 können beispielsweise als Blasen oder Ringe mit einer schnelleren Geschwindigkeit durch das Fluid strömen.

Die erste Kammer 51 ist von der zweiten Kammer 52 durch das volumenverändernde Mittel 6 getrennt. Die dritte Kammer 53 ist von der vierten Kammer 54 durch ein weiteres volumenveränderndes Mittel 6' getrennt. Die Besonderheit bei dieser vier-Kammerausgestaltungsvariante ist es, dass die zweite Kammer 52 mit der vierten Kammer 54 über einen Nebenstromkanal 55 in Verbindung steht. Durch diese besondere Ausgestaltungsvariante ist es möglich, einen synthetischen Jetantrieb innerhalb des Gehäuses 4 staubdicht auszubilden. D.h. die volumenverändernden Mittel 6, 6', welche z.B. als Piezoelemente ausgestaltet sind, werden durch eine staubige Luft nicht belastet. Insbesondere in der Prozessautomatisierung im industriellen Umfeld herrschen harte und raue Umweltbedingungen, wobei eine Umgebungsluft, welche als Kühlluft genutzt wird, stark staub- und feuchtigkeitsbelastet sein kann.

Das besondere an dieser Vierkammerausgestaltung ist, das die Umgebungsluft mittels des ersten Stromes 11 in die erste Kammer 51 geleitet wird und über eine Membran des volumenverändernden Mittel 6 von diesem getrennt ist. Es kann sich somit Schmutz aus der Umgebungsluft in der Kammer 51 absetzen ohne dass volumenverändernde Mittel 6 zu beeinträchtigen. Der Hauptantrieb des volumenverändernden Mittels 6 befindet sich nämlich in der zweiten Kammer 52 welche nur einmal mit einem entsprechenden Fluid, wie z.B. Luft gefüllt werden muss. Diese zweite Kammer 52 steht über den Nebenstromkanal 559 in hermetischer Verbindung mit der vierten Kammer 54. In der vierten Kammer 54 wiederum ist das weitere volumenverändernde Mittel 6' angeordnet, so dass auch dieses nicht mit einem Umgebungsfluid, wie z.B. staubbelasteter Luft in Berührung kommt. Nur wiederum die dritte Kammer 53 kann mit staubbelasteter Luft in Berührung kommen und der Staub kann sich, ohne Schaden zu verursachen, in der dritten Kammer 53 absetzen.

$$\texttt{Konstanter Querschnitt Kanal} = \texttt{h*b} = \texttt{r}^2\boldsymbol{\pi};$$

$$\texttt{identische Volumina} = \Delta\texttt{V}_{\texttt{SynJet}} = \texttt{V}_{\texttt{Kanal}}$$

$$\texttt{Strömungswiderstand F}_{\texttt{Kanal}} = \texttt{Strömungswiderstand F}_{\texttt{Lamellenkanin}}$$

$$\texttt{Q}_{\texttt{Gesant}} = \texttt{Q}_{\texttt{Ansaug}} + \texttt{Q}_{\texttt{Ausstoss}} + \texttt{Q}_{\texttt{Lamellen}} = \texttt{c*m*}(\Delta\texttt{T}_1 + \Delta\texttt{T}_2 + \Delta\texttt{T}_3)$$

## EP 2 282 335 A1

**Patentansprüche**

1. Kühlvorrichtung (1) zur Kühlung eines Bauteils (2), umfassend

   - einen Kühlkörper (3),
   - ein Gehäuse (4) mit einer inneren Kammer (5), wobei ein Volumen veränderndes Mittel (6) zum Zurückziehen eines Fluids in die Kammer (5) und zum Austreiben des Fluids aus der Kammer (5) ausgebildet ist, wobei das Zurückziehen einen ersten Strom (11) verursacht und das Austreiben Wirbel (7) verursacht, welche einen zweiten Strom (12) bilden, **dadurch gekennzeichnet, dass** ein Vorwärmmittel (8) dazu ausgestaltet ist den ersten Strom (11) und den zweiten Strom (12) zu führen und die Temperaturen,
   - der von dem ersten Strom (11) mitgeführten ersten Fluidmenge (V1) beim Zurückziehen von einer Anfangstemperatur (T0) auf eine erste Temperatur (T1) zu erhöhen, und
   - der von dem zweiten Strom (12) mitgeführten zweiten Fluidmenge (V2) von der ersten Temperatur (T1) auf eine zweite Temperatur (T2) zu erhöhen.

2. Kühlvorrichtung (1) nach Anspruch 1, wobei das Vorwärmmittel (8) einen ersten Kanal (21) und einen zweiten Kanal (22) aufweist.

3. Kühlvorrichtung (1) nach Anspruch 2, wobei die Kammer (5) eine erste Kammer (51) und eine zweite Kammer (52) aufweist.

4. Kühlvorrichtung (1) nach Anspruch 2 oder 3, wobei der erste Kanal (21) ein Volumen aufweist, welches der ersten Fluidmenge (V1) entspricht.

5. Kühlvorrichtung (1) nach einem der Ansprüche 1 bis 4, wobei der Kühlkörper (3) das Vorwärmmittel (8) als integrativen Bestandteil aufweist und ein Anteil der durch das Bauteil (2) in den Kühlkörper (3) fließenden Wärmestromes in das Vorwärmmittel (8) fließt.

6. Kühlvorrichtung (1) nach einem der Ansprüche 1 bis 5, wobei der Kühlkörper (3) eine Durchführung (3a) aufweist, welche derart angeordnet ist, das der zweite Strom (12) in die Durchführung (3a) strömt und sich die von dem zweiten Strom (12) mitgeführte zweite Fluidmenge (V2) von der zweiten Temperatur (T2) auf eine dritte Temperatur (T3) erhöht.

7. Kühlvorrichtung (1) nach einem der Ansprüche 1 bis 5, wobei das Vorwärmmittel (8) ein erste Ende (8a) und ein zweites Ende (8b) aufweist und eine Ansaugzone (9) zwischen dem Kühlkörper (3) und dem zweiten Ende (8b) angeordnet ist, wobei das erste Ende (8a) am Gehäuse (4) angeordnet ist.

8. Kühlvorrichtung (1) nach Anspruch 6 oder 7, wobei die Durchführung (3a) Leitmittel (30a, 30b) zum Erzwingen einer turbulenten Konvektion (13) aufweist.

9. Kühlvorrichtung (1) nach einem der Ansprüche 6 bis 8, wobei die Durchführung (3a) eine Austrittszone (10) im Bereich einer Auslassöffnung (10a) aufweist, welche derart gestaltet ist, das es zu einer Interferenz von Teilströmungen kommt und eine Schallkompensation erreichbar ist.

10. Kühlvorrichtung (1) nach einem der Ansprüche 1 bis 9, wobei der Kühlkörper (3) an einer Außenseite Kühllamellen (31,..,36) aufweist.

11. Kühlvorrichtung (1) nach einem der Ansprüche 3 bis 10, wobei die Kammer (5) weiterhin eine dritte Kammer (53) und eine vierte Kammer (54) aufweist.

12. Verfahren zum Betrieb einer Kühlvorrichtung (1), wobei

    - in einem Gehäuse (4) mit einer inneren Kammer (5), ein Volumen veränderndes Mittel (6) derart bewegt wird,
    - dass bei einer ersten Bewegungsrichtung ein Fluid in die Kammer (5) zurückgezogen wird und
    - bei einer zweiten Bewegungsrichtung das Fluid aus der Kammer (5) ausgetrieben wird,
    - wobei durch das Zurückziehen ein erster Strom (11) verursacht und durch das Austreiben Wirbel (7) verursacht werden, welche einen zweiten Strom (12) bilden, **dadurch gekennzeichnet, dass**
    - der erste Strom (11) durch ein Vorwärmmittel (8) geführt wird, wobei eine Temperatur der vom ersten Strom

(11) mitgeführten ersten Fluidmenge (V1) beim Zurückziehen von einer Anfangstemperatur (T0) auf eine erste Temperatur (T1) durch das Vorwärmmittel (8) erhöht wird und
- die Temperatur von der durch den zweiten Strom (12) mitgeführten zweiten Fluidmenge (V2) von der ersten Temperatur (T1) auf eine zweite Temperatur (T2) durch das Vorwärmmittel (8) erhöht wird.

13. Verfahren nach Anspruch 12, wobei das Volumen verändernde Mittel (6) derart angeregt wird, dass es ein oszillierendes Bewegungsmuster ausführt.

14. Verfahren nach Anspruch 12 oder 13, wobei die erste Bewegungsrichtung solange beibehalten wird, dass das Volumen der zurückgezogenen ersten Fluidmenge (V1) dem Volumen eines ersten Kanals (21) des Vorwärmmittels (8) entspricht.

15. Verfahren nach einem der Ansprüche 12 bis 14, wobei die zweite Bewegungsrichtung solange beibehalten wird, dass das ausgetriebene Volumen der ersten Fluidmenge (V1) dem Volumen des ersten Kanals (21) des Vorwärmmittels (8) entspricht und ein alternierender Austausch von Fluidmengen (V1, V2) aus den Vorwärmmittel (8) durchgeführt wird.

16. Verfahren nach einem der Ansprüche 12 bis 15, wobei die Wirbel (7) des zweiten Stroms (12) in eine Durchführung (3a) eines Kühlkörpers (3) geleitet werden und die von dem zweiten Strom (12) mitgeführte zweite Fluidmenge (V2) von der zweiten Temperatur (T2) auf eine dritte Temperatur (T3) erhöht wird.

17. Verfahren nach Anspruch 16, wobei die Wirbel (7) von einem Leitmittel (30a, 30b) in der Durchführung (3a) abgelenkt werden und eine turbulente Konvektion (13) erzeugt wird.

18. Verfahren nach einem der Ansprüche 15 bis 17, wobei die Bewegungsrichtungen abwechselnd hin und her ausgeführt werden, dass während einer ersten Zeitdauer für die erste Bewegungsrichtung (41), in welcher die erste Fluidmenge (V1) über eine Ansaugzone (9) in den ersten Kanal (21) gesogen wird, die zweite Fluidmenge (V2) aus einem zweiten Kanal (22) ausgetrieben und in die Durchführung (3a) geleitet wird, wobei nach einem Umkehren der Bewegungsrichtung von der ersten Bewegungsrichtung (41) in die zweite Bewegungsrichtung (42), die erste Fluidmenge (V1) in den zweiten Kanal (22) gesogen und die zweite Fluidmenge (V2) aus dem ersten Kanal (21) in die Durchführung (3a) geleitet wird.

19. Verfahren nach Anspruch 17 oder 18, wobei eine bidirektionale Wärmeaufnahme durch die Ströme (11, 12) ausgeführt und die Ströme (11, 12) bis zu einer Austrittszone (10) getrennt geführt werden und bei Austritt eine Schallemissionsreduktion ausgeführt wird.

FIG 1

FIG 2

FIG 3

FIG 4

FIG 5

FIG 6

FIG 7

EP 2 282 335 A1

Europäisches
Patentamt
European
Patent Office
Office européen
des brevets

**EUROPÄISCHER RECHERCHENBERICHT**

Nummer der Anmeldung

EP 09 16 7251

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2009/086416 A1 (ISHIKAWA HIROICHI [JP] ET AL) 2. April 2009 (2009-04-02) <br> * Abbildung 54 * <br> ----- | 1-3,7,8, 10,11, 13,14 | INV. H01L23/473 |
| X | EP 1 762 725 A (SONY CORP [JP]) 14. März 2007 (2007-03-14) <br> * Abbildungen 3,5,6 * <br> ----- | 1-3,7,8, 10,11, 13,14 | |
| X | US 2007/119573 A1 (MAHALINGAM RAGHAVENDRAN [US] ET AL) 31. Mai 2007 (2007-05-31) <br> * Abbildung 68 * <br> ----- | 1-3,7,8, 10,11, 13,14 | |

RECHERCHIERTE SACHGEBIETE (IPC)

H01L

Der vorliegende Recherchenbericht wurde für alle Patentansprüche erstellt

| Recherchenort | Abschlußdatum der Recherche | Prüfer |
|---|---|---|
| Den Haag | 28. Januar 2010 | Kästner, Martin |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

13

# EP 2 282 335 A1

**ANHANG ZUM EUROPÄISCHEN RECHERCHENBERICHT
ÜBER DIE EUROPÄISCHE PATENTANMELDUNG NR.**

EP 09 16 7251

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-01-2010

| Im Recherchenbericht angeführtes Patentdokument | Datum der Veröffentlichung | Mitglied(er) der Patentfamilie | Datum der Veröffentlichung |
|---|---|---|---|
| US 2009086416 A1 | 02-04-2009 | JP 2006320887 A<br>WO 2006114934 A1<br>KR 20080007438 A | 30-11-2006<br>02-11-2006<br>21-01-2008 |
| EP 1762725 A | 14-03-2007 | CN 1906416 A<br>JP 2005264811 A<br>WO 2005090789 A1<br>KR 20070003774 A<br>US 2009219686 A1 | 31-01-2007<br>29-09-2005<br>29-09-2005<br>05-01-2007<br>03-09-2009 |
| US 2007119573 A1 | 31-05-2007 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6588497 B1
- US 5758823 A1
- US 5988522 A1
- US 7252140 B2